# DEMANDE DE BREVET EUROPEEN

(11) **EP 2 573 808 A1**
(43) Date de publication de la demande: **27.03.2013**
(21) Numéro de dépôt: 12185745.2
(22) Date de dépôt: 24.09.2012
(51) Int. Cl.: H01L 21/84, H01L 27/12, H01L 29/786

(54) **Circuit integré en technologie FDSOI avec partage de caisson et moyens de polarisation des plans de masse de dopage opposés présents dans un même caisson**

(30) Priorité: 26.09.2011 FR 1158544
(71) Demandeur: Commissariat à l'Énergie Atomique et aux Énergies Alternatives, 75015 Paris (FR)
(72) Inventeur: Noel, Jean-Philippe, 38330 MONTBONNOT SAINT MARTIN (FR); Giraud, Bastien, 38000 GRENOBLE (FR); Thomas, Olivier, 38420 REVEL (FR)
(74) Mandataire: Guérin, Jean-Philippe

(57) **Abrégé**

L'invention concerne un circuit intégré (2) comprenant un empilement d'un substrat semi-conducteur (sub), d'une couche isolante (bn2) et d'une couche semi-conductrice, comprenant :
-un premier composant électronique (n2) formé :
-un circuit de polarisation configuré pour générer une première tension de polarisation ;
-des première (vn12) et deuxième interconnexions, recevant la première tension de polarisation ;
-une première tranchée d'isolation (47) séparant le premier composant électronique (n2) des première et deuxième interconnexions ;
-un premier plan de masse (gpl-n) présentant un premier type de dopage ;
-un premier caisson (wl-p) présentant un deuxième type de dopage opposé au premier type, disposé à l'aplomb du premier plan de masse (gpl-n), et s'étendant sous la première tranchée d'isolation (47) et jusqu'en contact avec la deuxième interconnexion (vn11).

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique en statique et en dynamique pour des performances équivalentes, grâce à un meilleur contrôle électrostatique du canal par la grille. Du fait d'un canal non dopé, les dispersions des caractéristiques électriques sont également plus faibles. De tels circuits induisent également des capacités parasites plus faibles, qui permettent d'améliorer la vitesse de commutation. De plus, le phénomène de déclenchement parasite (latchup en langue anglaise) rencontré par les transistors MOS en technologie Bulk peut être évité au profit de la robustesse de fonctionnement, du fait de la présence de la couche d'oxyde isolante. De tels circuits s'avèrent donc particulièrement adaptés pour des applications de type SoC. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques. La réalisation des circuits intégrés SOI reste en outre relativement semblable à celle de la technologie Bulk.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on choisit des portes logiques à accès rapide ou des portes logiques à faible consommation dans des bibliothèques de portes logiques. En technologie Bulk, la modulation du niveau de tension de seuil de transistors de même type est effectuée en différenciant le niveau de dopage de leur canal. Cependant, en technologie FDSOI (pour Fully Depleted Silicium On Insulator en langue anglaise, désignant du silicium totalement déserté sur isolant), le dopage du canal est quasiment nul. Ainsi, le niveau de dopage du canal des transistors ne peut donc pas présenter de variations importantes sans perdre les avantages associés, ce qui empêche de différencier les tensions de seuil en jouant sur ce dopage. Les tensions de seuils en technologie FDSOI à canal non dopé sont ainsi déterminées essentiellement par le travail de sortie de la grille. Un travail de sortie légèrement en dessous du milieu de la bande interdite (midgap), dit de type N, pour les nMOS, est généralement souhaité pour obtenir des tensions de seuil entre 0.2 et 0.5V. De manière symétrique, un travail de sortie légèrement au dessus du milieu de la bande interdite (midgap), dit de type P, pour les pMOS, est généralement souhaité pour obtenir des tensions de seuil entre -0.2 et -0.5V.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT, de transistors à haute tension de seuil dits HVT et de transistors à tension de seuil moyenne dits SVT.

Les transistors d'un circuit intégré sont généralement disposés selon des doubles rangées alternées de nMOS et de pMOS. Une rangée de transistors nMOS est séparée d'une rangée de transistors pMOS par l'intermédiaire d'une tranchée d'isolation. Afin de disposer de transistors présentant des tensions de seuil différentes dans une même rangée, certains transistors sont ménagés à l'aplomb d'un plan de masse à dopage de type N, tandis que d'autres transistors sont ménagés à l'aplomb d'un plan de masse à dopage de type P.

Le document US2003/178622 (D1) décrit un circuit intégré comprenant un empilement d'un substrat semi-conducteur, d'une couche isolante enterrée et d'une couche semi-conductrice. Un transistor est formé dans et sur ladite couche semi-conductrice. Un circuit de polarisation est configuré pour générer une première tension de polarisation. Une première interconnexion de type VIA reçoit la première tension de polarisation. Une première tranchée d'isolation sépare le transistor de la première interconnexion et d'une deuxième interconnexion dans la couche semi-conductrice. Un premier caisson présente un dopage p, est disposé sous la couche isolante enterrée à l'aplomb du transistor, et s'étend sous la première tranchée d'isolation et jusqu'en contact avec la première interconnexion. Un deuxième caisson présente un dopage n, est disposé à l'aplomb du premier caisson et s'étend sous la première tranchée d'isolation et jusqu'en contact avec la deuxième interconnexion. La polarisation du premier caisson est variable pour moduler la tension de seuil du transistor. Le deuxième caisson isole le premier caisson d'un substrat dopé p et présente une polarisation supérieure à celle du premier caisson afin de limiter les fuites.

On constate d'une part que le temps de diffusion de la polarisation à l'intérieur d'un plan de masse est relativement long, et d'autre part qu'une conception relativement complexe du circuit nécessaire pour éviter de former des diodes parasites conductrices entre les différents dopages des semiconducteurs en fonction de la polarisation qui leur est appliquée. Par ailleurs, il s'avère que la formation de contacts en vue de polariser les différents types de plans de masse s'avère complexe et implique l'utilisation d'une surface non négligeable de cellules de transition, au détriment de la densité d'intégration.

L'invention vise à résoudre un ou plusieurs de ces inconvénients. L'invention porte ainsi sur un circuit intégré comprenant un empilement d'un substrat semi-conducteur, d'une couche isolante enterrée et d'une couche semi-conductrice, comprenant :
- un premier composant électronique formé dans et/ou sur ladite couche semi-conductrice :
- un circuit de polarisation configuré pour générer une première tension de polarisation ;
- des première et deuxième interconnexions de type VIA, sur lesquelles le circuit de polarisation applique une même tension de polarisation égale à la première tension de polarisation ;
- au moins une première tranchée d'isolation séparant le premier composant électronique des première et deuxième interconnexions dans la couche semi-conductrice ;
- un premier plan de masse présentant un premier type de dopage, disposé sous la couche isolante enterrée à l'aplomb du premier composant électronique, et s'étendant sous la première tranchée d'isolation et jusqu'en contact avec la première interconnexion ;
- un premier caisson présentant un deuxième type de dopage opposé au premier type, disposé à l'aplomb du premier plan de masse, et s'étendant sous la première tranchée d'isolation et jusqu'en contact avec la deuxième interconnexion.

Selon une variante, le circuit comprend en outre :
- un deuxième composant électronique formé dans et/ou sur ladite couche semi-conductrice :
- un deuxième plan de masse présentant le deuxième type de dopage, disposé à l'aplomb de la couche isolante enterrée à l'aplomb du deuxième composant électronique, le premier caisson s'étendant jusqu'en contact avec le deuxième plan de masse.

Selon encore une variante, ledit premier caisson comporte une jonction présentant le deuxième type de dopage et s'étendant dans une même couche que les premier et deuxième plans de masse jusqu'à la deuxième interconnexion.

Selon une autre variante, les premier et deuxième composants électroniques sont des transistors FDSOI de même type nMOS ou pMOS.

Selon encore une autre variante, les premier et deuxième transistors sont disposés dans une même rangée de transistors, le deuxième plan de masse étant entouré de semi-conducteur présentant le premier type de dopage dans la couche incluant les premier et deuxième plans de masse.

Selon une variante, les premier et deuxième transistors sont disposés dans une même rangée de transistors, le deuxième plan de masse s'étendant sur la largeur de la rangée.

Selon encore une variante, le circuit comprend une jonction électrique connectant lesdites première et deuxième interconnexions dans la couche semi-conductrice, lesdites première et deuxième interconnexions étant ménagées dans une même cellule de répétition présentant une largeur d'un pas de grille du premier transistor.

Selon une autre variante, le circuit ne comprend pas de jonction électrique connectant lesdites première et deuxième interconnexions dans la couche semi-conductrice, lesdites première et deuxième interconnexions étant ménagées dans une même cellule de répétition présentant une largeur d'un pas de grille du premier transistor.

Selon une autre variante, le circuit ne comprend pas de jonction électrique connectant lesdites première et deuxième interconnexions dans la couche semi-conductrice, lesdites première et deuxième interconnexions étant ménagées dans une même cellule de répétition présentant une largeur de deux pas de grille du premier transistor.

Selon une autre variante, le circuit comprend en outre :
- un troisième transistor FDSOI d'un type opposé au premier transistor, formé dans et/ou sur ladite couche semi-conductrice ;
- un quatrième transistor FDSOI du même type que le troisième transistor et formé dans et/ou sur ladite couche semi-conductrice ;
- le circuit de polarisation étant configuré pour générer une deuxième tension de polarisation ;
- des troisième et quatrième interconnexions de type VIA, sur lesquelles le circuit de polarisation applique une même tension de polarisation égale à la deuxième tension de polarisation ;
- au moins une deuxième tranchée d'isolation séparant le troisième transistor des troisième et quatrième interconnexions dans la couche semi-conductrice ;
- un troisième plan de masse présentant un troisième type de dopage, disposé sous la couche isolante enterrée à l'aplomb du troisième transistor, et s'étendant sous la première tranchée d'isolation et jusqu'en contact avec la troisième interconnexion ;
- un deuxième caisson présentant un quatrième type de dopage opposé au troisième type, disposé à l'aplomb du troisième plan de masse, et s'étendant sous la première tranchée d'isolation et jusqu'en contact avec la quatrième interconnexion ;
- un quatrième plan de masse présentant le quatrième type de dopage, disposé à l'aplomb de la couche isolante enterrée à l'aplomb du quatrième transistor, le deuxième caisson s'étendant jusqu'en contact avec le quatrième plan de masse.

Selon encore une variante, les premier et deuxième caissons présentent un même type de dopage.

Selon encore une autre variante, ledit premier caisson est séparé du substrat par un caisson profondément enterré ménagé à l'aplomb du premier caisson.

Selon une variante, ledit substrat présente un dopage de type P.

D'autres caractéristiques et avantages de l'invention ressortiront clairement de la description qui en est faite ci-après, à titre indicatif et nullement limitatif, en référence aux dessins annexés, dans lesquels :
- la figure 1 illustre schématiquement une vue en coupe de dessus d'un circuit intégré au niveau des caissons ;
- la figure 2 est une vue en coupe schématique au niveau des caissons d'un premier exemple d'une zone d'intégration ;
- les figures 3 et 4 sont des vues de dessus en coupe d'une partie de zone d'intégration selon un développement envisageable mais non optimal, respectivement au niveau des caissons et des plans de masse ;
- la figure 5 est une vue en coupe de côté de la zone des figures 3 et 4 au niveau d'une cellule de répétition ;
- la figure 6 est une vue en coupe de côté de la zone des figures 3 et 4 au niveau d'une rangée de nMOS ;
- la figure 7 est une vue en coupe de côté de la zone des figures 3 et 4 au niveau d'un transistor nMOS et d'un transistor pMOS adjacent ;
- les figures 8 et 9 sont des vues de dessus en coupe d'une partie d'une zone d'intégration selon une variante de l'invention, respectivement au niveau des caissons et des plans de masse ;
- la figure 10 est une vue en coupe de côté de la zone des figures 8 et 9 au niveau d'une cellule de répétition ;
- la figure 11 est une vue en coupe de face de la zone des figures 8 et 9 au niveau d'une rangée de nMOS ;
- la figure 12 est une autre vue en coupe de face de la zone des figures 8 et 9 au niveau d'une rangée de nMOS ;
- la figure 13 est une vue en coupe de côté de la zone des figures 8 et 9 au niveau d'un transistor nMOS et d'un transistor pMOS adjacent ;
- les figures 14 à 16 représentent différentes variantes de cellules de répétition en coupe au niveau du caisson ;
- les figures 17 à 19 représentent différentes variantes de cellules de répétition en coupe au niveau du plan de masse ;
- les figures 20 et 21 sont des vues de dessus en coupe d'une partie d'une autre variante de zone d'intégration, respectivement au niveau des caissons et des plans de masse ;
- la figure 22 est une vue en coupe de face de la zone des figures 20 et 21 au niveau d'une rangée de pMOS ;
- la figure 23 est une autre vue en coupe de face de la zone des figures 20 et 21 au niveau d'une rangée de pMOS ;
- la figure 24 est une vue en coupe de côté de la zone des figures 20 et 21 au niveau d'une cellule de répétition ;
- la figure 25 est une vue en coupe de côté de la zone des figures 20 et 21 au niveau d'un transistor nMOS et d'un transistor pMOS adjacent ;
- les figures 26 à 29 représentent différentes variantes de cellules de répétition en coupe au niveau du caisson ;
- les figures 30 à 33 représentent différentes variantes de cellules de répétition en coupe au niveau du plan de masse ;
- les figures 34 et 35 représentent différentes variantes de cellules de répétition en coupe au niveau du caisson ;
- les figures 36 et 37 représentent différentes variantes de cellules de répétition en coupe au niveau du plan de masse ;
- les figures 38 et 39 sont des vues de dessus en coupe d'une partie d'une autre variante de zone d'intégration, respectivement au niveau des caissons et des plans de masse ;
- les figures 40 à 42 représentent différentes variantes de cellules de répétition en coupe au niveau du caisson ;
- les figures 43 à 45 représentent différentes variantes de cellules de répétition en coupe au niveau du plan de masse ;
- les figures 46 et 47 sont des vues de dessus en coupe d'une partie d'une autre variante de zone d'intégration, respectivement au niveau des caissons et des plans de masse ;
- les figures 48 à 50 représentent différentes variantes de cellules de répétition en coupe au niveau du caisson ;
- les figures 51 à 53 représentent différentes variantes de cellules de répétition en coupe au niveau du plan de masse ;
- les figures 54 et 55 sont des vues de dessus en coupe d'une partie d'une autre variante de zone d'intégration, respectivement au niveau des caissons et des plans de masse.

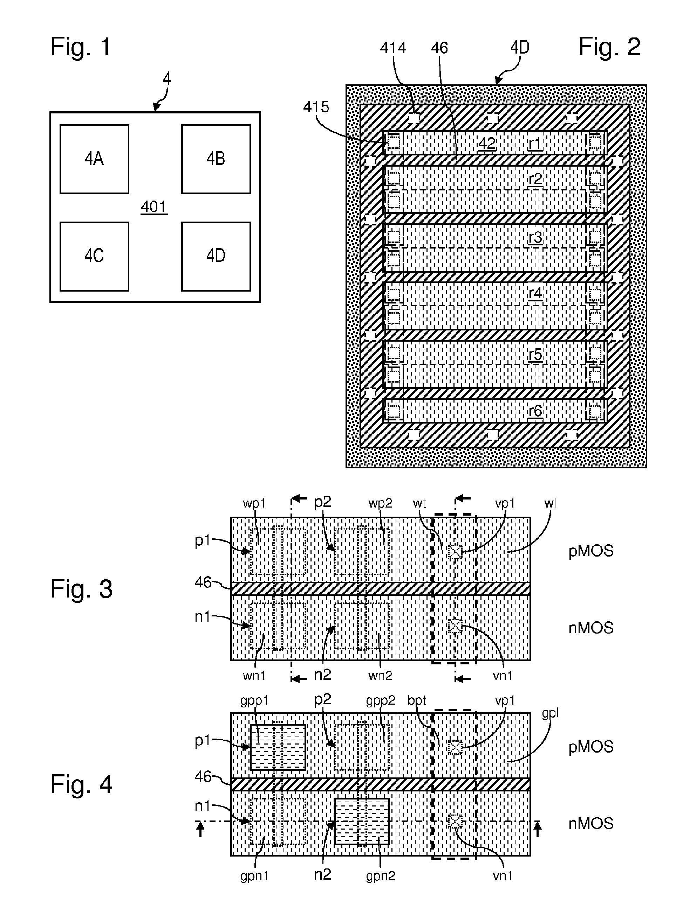

La figure 1 illustre un circuit intégré 4 incluant d'une part deux zones 4A et 4B comportant des cellules mémoires de type SRAM et d'autre part des zones 4C et 4D comportant des portes logiques. Ces différentes zones 4A à 4D sont réalisées sur un même substrat de silicium 401.

La figure 2 est une vue en coupe schématique de la zone 4D au niveau d'une couche de caisson. La zone 4D comporte notamment des transistors comportant chacun un empilement de grille. Ces transistors sont typiquement de type FDSOI. Les transistors de la zone 4D sont ménagés de façon connue en soi sur une couche d'isolant enterrée dite ultra-fine (typiquement désignée par l'acronyme FDSOI). La couche d'isolant enterrée est ménagée sur une couche de plan de masse. La couche de plan de masse est ménagée sur une couche de caisson. La couche de caisson est ménagée sur une couche de caisson profondément enterré de type N (désignée par le terme deep n-well) en langue anglaise. La couche de caisson profondément enterré de type N est elle-même ménagée sur le substrat de silicium 401, typiquement dopé P.

Dans la zone 4D, on distingue une zone 42 dopée P et formant les caissons de rangées r1 à r6 de transistors. On distingue des contacts 414 destinés à polariser le caisson profondément enterré à dopage de type N. On distingue également des contacts 415 destinés à polariser les plans de masse des transistors aux extrémités des rangées r1 à r6.

On distingue une zone 46 formant des tranchées d'isolation profonde, isolant les rangées de transistors adjacentes jusqu'à la couche de caisson. Chaque rangée contient des transistors d'un même type, isolés par des tranchées d'isolation. Les rangées adjacentes forment une alternance de transistors nMOS et pMOS.

Les figures 3 à 7 illustrent un exemple de structure possible de la zone 4D. Les figures 3 à 7 sont différentes vues en coupe au niveau d'un groupe de transistors appartenant à des rangées adjacentes et/ou comportant des plans de masse dont les dopages sont de types opposés.

Le groupe de transistors illustré comporte des transistors pMOS dans une première rangée et comporte des transistors nMOS dans une seconde rangée adjacente. Les sources, drains et grilles des transistors sont ménagés dans et/ou sur une couche active semi-conductrice, la couche semi-conductrice étant ménagée sur une couche isolante enterrée. Ces transistors sont de type FDSOI. La première rangée et la seconde rangée sont séparées par une tranchée d'isolation 46. La première rangée comporte un transistor p1 et un transistor p2. Les transistors p1 et p2 sont séparés par une tranchée d'isolation (non illustrée) dans l'épaisseur de la couche active semi-conductrice. La deuxième rangée comporte un transistor n1 et un transistor n2. Les transistors n1 et n2 sont séparés par une tranchée d'isolation 49 dans l'épaisseur de la couche active semi-conductrice. La tranchée d'isolation 49 sépare également le transistor p1 de l'interconnexion vp1 dans l'épaisseur de la couche active semi-conductrice.

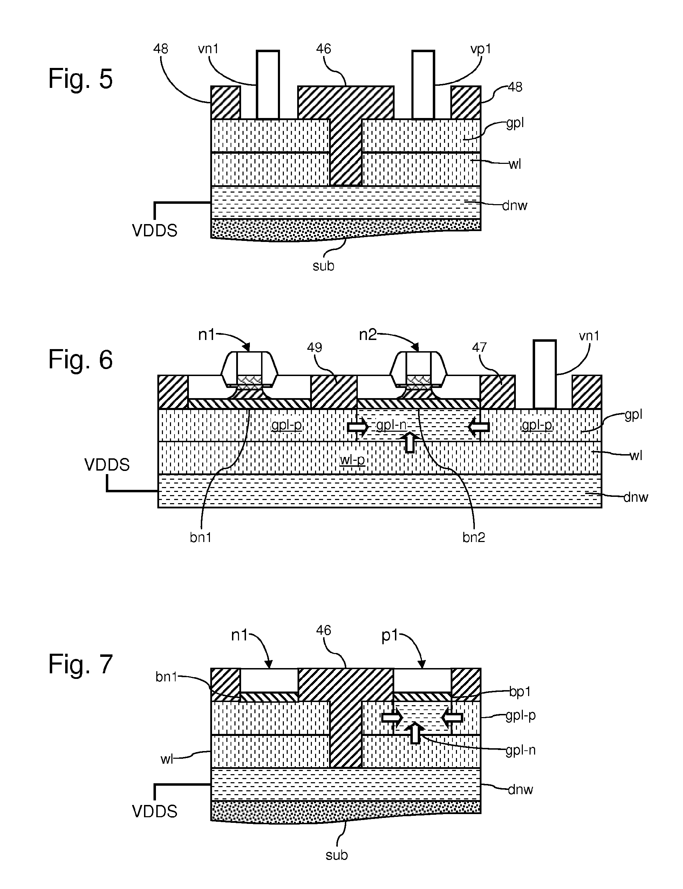

La figure 3 est une vue en coupe de dessus de la zone 4D au niveau de sa couche de caisson wl. La figure 4 est une vue en coupe de dessus de la zone 4D au niveau de sa couche de plan de masse gpl. La figure 5 est une vue en coupe de côté de la zone 4D au niveau d'interconnexions vp1 et vn1 de type VIA. La figure 6 est une vue en coupe de face de la zone 4D au niveau de la rangée de transistors nMOS. La figure 7 est une vue en coupe de côté de la zone 4D au niveau d'une couche active de transistors.

Dans un souci de lisibilité, les interconnexions vp1 et vn1 ont été représentées en projection en pointillé sur les figures 3 et 4. De façon similaire, la délimitation de la couche active des différents transistors a été représentée en projection sur les figures 3 et 4.

Des interconnexions de type VIA vn1 et vp1 sont ménagées à travers la couche active semi-conductrice. L'interconnexion vp1 est destinée à polariser les plans de masse des transistors pMOS. L'interconnexion vn1 est destinée à polariser les plans de masse des transistors nMOS.

Une interconnexion de type VIA désigne généralement une jonction conductrice ménagée dans un trou traversant différentes couches de silicium. De telles interconnexions sont ainsi usuellement intégrées afin de réaliser une interconnexion inter-couches à l'intérieur du circuit intégré.

La couche de caisson wl présente deux zones semi-conductrices séparées par la tranchée d'isolation 46. Les deux zones semi-conductrices comportent un dopage de type P. Les parties de caisson wp1, wp2, wn1 et wn2 disposées respectivement à l'aplomb des transistors p1, p2, n1 et n2 comportent ainsi un même dopage de type P. La partie de caisson wt est disposée à l'aplomb d'une cellule de répétition (pour Well Tap en langue anglaise) incluant les interconnexions vp1 et vn1.

La couche de plan de masse gpl présente deux zones semi-conductrices séparées par la tranchée d'isolation 46. Les deux zones semi-conductrices comportent un dopage de type P sur l'ensemble de leur surface, à l'exception des zones de plan de masse gpp1 et gpn2 disposées à l'aplomb des transistors p1 et n2. Les zones de plan de masse gpp1 et gpn2 présentent ainsi un dopage de type N. Les zones de plan de masse gpp2 et gpn1 présentent ainsi un dopage de type P. La zone de plan de masse bpt est disposée à l'aplomb de la cellule de répétition incluant les interconnexions vp1 et vn1.

L'interconnexion vn1 s'étend en profondeur jusqu'au contact de la couche de plan de masse gpl, sur une zone gpl-p dopée P. L'interconnexion vp1 s'étend en profondeur jusqu'au contact de la couche de plan de masse gpl, sur une zone gpl-p dopée P. Un circuit de polarisation non illustré applique des tensions de polarisation sur les interconnexions vp1 et vn1.

La couche de caisson wl est séparée du substrat sub par l'intermédiaire d'un caisson profondément enterré à dopage de type N dnw, afin de pouvoir appliquer une polarisation différente aux plans de masse et au substrat sub. Dans l'exemple, le substrat sub est polarisé à une tension Vdds. La tranchée d'isolation 46 s'étend en profondeur jusqu'au caisson profondément enterré dnw afin d'assurer une isolation entre les rangées de transistors. Des tranchées d'isolation 48 délimitent la rangée des transistors pMOS par rapport à une rangée de transistors pMOS adjacente, et la rangée des transistors nMOS par rapport à une rangée de transistors nMOS adjacente. Les tranchées d'isolation 48 assurent une isolation entre ces rangées adjacentes dans l'épaisseur de la couche active semi-conductrice.

La polarisation du plan de masse gpp1 est réalisée par l'interconnexion vp1 par l'intermédiaire de la zone de plan de masse gpl-p et par l'intermédiaire de la couche de caisson wl, formant un trajet semi-conducteur dopé P. La polarisation du plan de masse gpp2 est réalisée par l'interconnexion vp1 par l'intermédiaire de la zone de plan de masse gpl-p formant un trajet semi-conducteur dopé P. La polarisation du plan de masse gpn1 est réalisée par l'interconnexion vn1 par l'intermédiaire de la zone de plan de masse gpl-p et par l'intermédiaire de la couche de caisson wl, formant un trajet semi-conducteur dopé P. La polarisation du plan de masse gpn2 est réalisée par l'interconnexion vn1 par l'intermédiaire de la zone de plan de masse gpl-p formant un trajet semi-conducteur dopé P.

Une telle structure présente cependant l'inconvénient de nécessiter un temps de polarisation non négligeable (pouvant atteindre plusieurs secondes) des plans de masse à dopage de type N. En effet, la polarisation des plans de masse de type N repose ici sur la génération/recombinaison des porteurs à leur interface avec la couche de plan de masse environnante dopée P et à leur interface avec la couche de caisson dopée P, comme illustré aux figures 6 et 7.

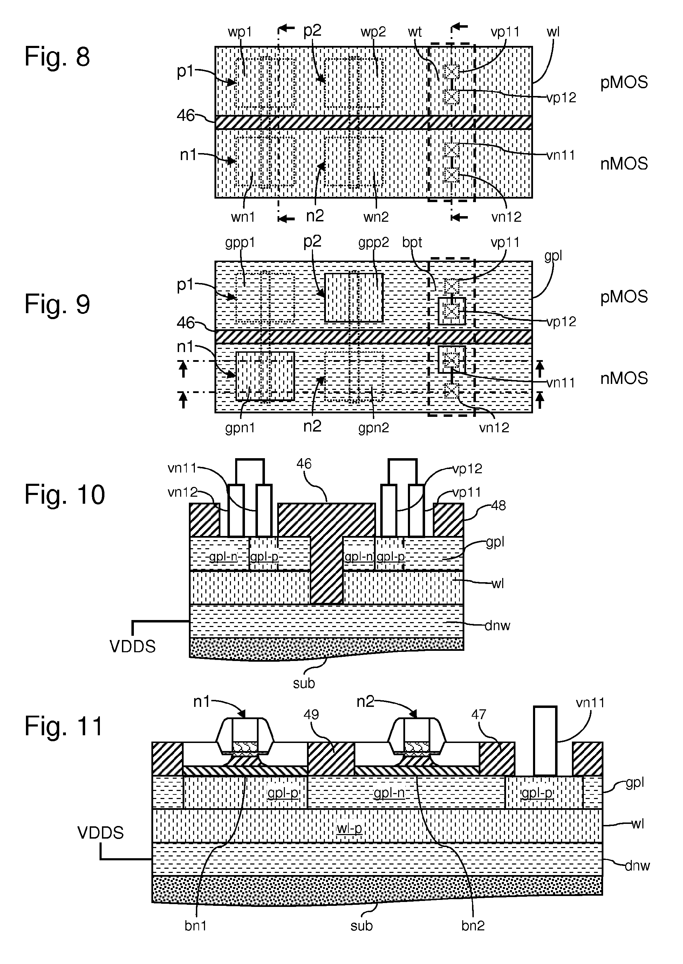

Les figures 8 à 13 illustrent une première variante de structure de la zone 4D selon l'invention, visant à optimiser son fonctionnement. Les figures 8 à 13 sont différentes vues en coupe au niveau d'un groupe de transistors appartenant à des rangées adjacentes et/ou comportant des plans de masse dont les dopages sont de types opposés.

Le groupe de transistors illustré comporte des transistors pMOS dans une première rangée et comporte des transistors nMOS dans une seconde rangée adjacente. Des cellules de répétition sont disposées à intervalles réguliers dans les rangées. Les sources, drains et grilles des transistors sont ménagés dans et/ou sur une couche active semi-conductrice, la couche semi-conductrice étant ménagée sur une couche isolante enterrée. La couche isolante peut avantageusement être d'épaisseur dite ultra-fine, typiquement comprise entre 10 et 50 nm. Ces transistors sont de type FDSOI. La couche active de silicium d'un transistor nMOS comporte une source dopée N, un canal, et un drain dopé N. La couche active de silicium d'un transistor pMOS comporte une source dopée P, un canal, et un drain dopé P. Le canal est recouvert par une couche d'oxyde de grille. L'oxyde de grille est surmonté par un empilement de grille comprenant une couche métallique et une couche de polysilicium. L'empilement est délimité latéralement par des espaceurs.

La première rangée et la seconde rangée sont séparées par une tranchée d'isolation 46. La première rangée comporte un transistor p1 et un transistor p2. Les transistors p1 et p2 sont séparés par une tranchée d'isolation (non illustrée) dans l'épaisseur de la couche active semi-conductrice. La deuxième rangée comporte un transistor n1 et un transistor n2. Les transistors n1 et n2 sont séparés par une tranchée d'isolation 49 dans l'épaisseur de la couche active semi-conductrice.

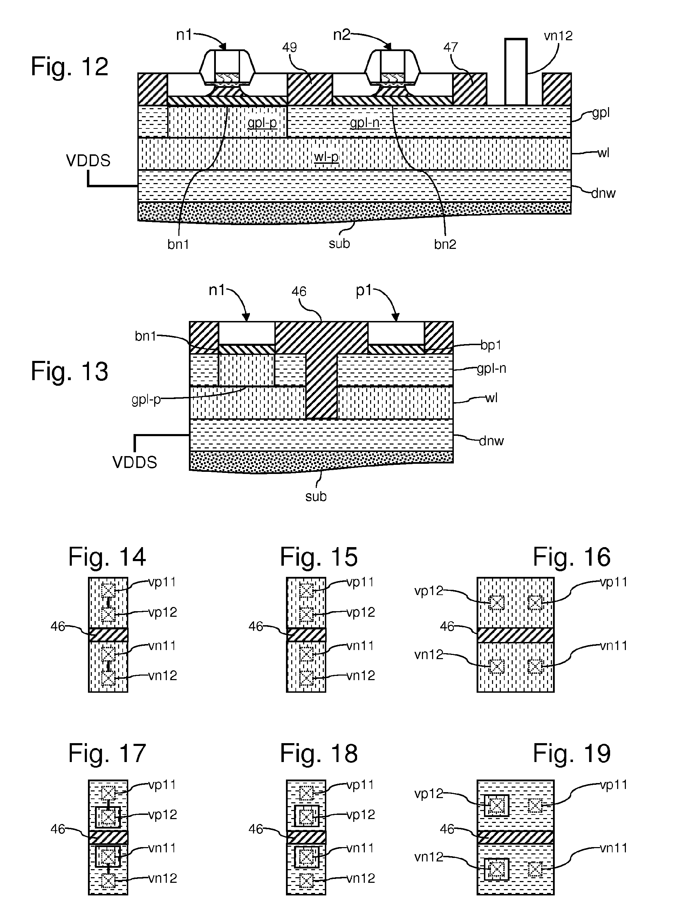

La figure 8 est une vue en coupe de dessus de la zone 4D au niveau de sa couche de caisson wl. La figure 9 est une vue en coupe de dessus de la zone 4D au niveau de sa couche de plan de masse gpl. La figure 10 est une vue en coupe de côté de la zone 4D au niveau d'interconnexions vp11, vp12, vn11 et vn12 de type VIA. La figure 11 est une vue en coupe de face de la zone 4D au niveau de la rangée de transistors nMOS et de l'interconnexion vn11. La figure 12 est une vue en coupe de face de la zone 4D au niveau de la rangée de transistors nMOS et de l'interconnexion vn12. La figure 13 est une vue en coupe de côté de la zone 4D au niveau d'une couche active de transistors.

Dans un souci de lisibilité, les interconnexions vp11, vp12, vn11 et vn12 ont été représentées en projection en pointillés sur les figures 8 et 9. De façon similaire, la délimitation de la couche active des différents transistors a été représentée en projection sur les figures 8 et 9.

Les interconnexions de type VIA vp11, vp12, vn11 et vn12 sont ménagées à travers la couche active semi-conductrice et la couche isolante enterrée. Les interconnexions vp11 et vp12 sont destinées à polariser les plans de masse des transistors pMOS. Les interconnexions vn11 et vn12 sont destinées à polariser les plans de masse des transistors nMOS.

La couche de caisson wl présente deux zones semi-conductrices séparées par la tranchée d'isolation 46. Les deux zones semi-conductrices comportent un dopage de type P. Les zones de caisson wp1, wp2, wn1 et wn2 disposées respectivement à l'aplomb des transistors p1, p2, n1 et n2 comportent ainsi un même dopage de type P. La zone de caisson wt est disposée à l'aplomb d'une cellule de répétition incluant les interconnexions vp11, vp12, vn11 et vn12.

La couche de plan de masse gpl présente deux zones semi-conductrices séparées par la tranchée d'isolation 46. Les deux zones semi-conductrices comportent un dopage de type N sur l'ensemble de leur surface, à l'exception des zones de plan de masse gpp2 et gpn1 disposées à l'aplomb des transistors p2 et n1. Les zones de plan de masse gpp2 et gpn1 présentent ainsi un dopage de type P et forment comme des îlots dans une zone de plan de masse gpl-n dopée N. Les zones de plan de masse gpp1 et gpn2 présentent ainsi un dopage de type N. La zone de plan de masse bpt est disposée à l'aplomb de la cellule de répétition incluant les interconnexions vp11, vp12, vn11 et vn12.

Les plans de masse permettent d'améliorer le contrôle électrostatique des transistors en limitant la pénétration des champs électriques générés par le drain et la source sous le canal. La réduction du couplage électrostatique latéral réduit les effets canaux courts et limite l'effet de déplétion par le drain (effet DIBL).

Les interconnexions vp12 et vn11 s'étendent en profondeur jusqu'au contact de la couche de plan de masse gpl, sur une zone gpl-p dopée P. Les interconnexions vp11 et vn12 s'étendent en profondeur jusqu'au contact de la couche de plan de masse gpl, sur une zone gpl-n dopée N. Un circuit de polarisation non illustré applique des tensions de polarisation sur les interconnexions vp11, vp12, vn11 et vn12. Une même tension de polarisation est appliquée sur les interconnexions vp11 et vp12. Une même tension de polarisation est appliquée sur les interconnexions vn11 et vn12. La tension de polarisation de l'interconnexion vp11 pourra être distincte de la tension de polarisation de l'interconnexion vin11.

La couche de caisson wl est séparée du substrat sub par l'intermédiaire d'un caisson profondément enterré à dopage de type N dnw, afin de pouvoir appliquer une polarisation différente aux plans de masse et au substrat sub sans risque de créer une jonction p-n conductrice parasite. Dans l'exemple, le caisson profondément enterré dnw est polarisé à une tension Vdds. La tranchée d'isolation 46 s'étend en profondeur jusqu'au caisson profondément enterré dnw. La tranchée d'isolation 46 et le caisson profondément enterré dnw assurent une isolation entre les rangées de transistors nMOS et pMOS. Des tranchées d'isolation 48 délimitent la rangée des transistors pMOS par rapport à une rangée de transistors pMOS adjacente, et la rangée des transistors nMOS par rapport à une rangée de transistors nMOS adjacente. Les tranchées d'isolation 48 assurent une isolation entre ces rangées adjacentes dans l'épaisseur de la couche active semi-conductrice.

La polarisation du plan de masse gpp1 est réalisée par l'interconnexion vp11 par l'intermédiaire de la zone de plan de masse gpl-n formant un trajet semi-conducteur dopé N. La polarisation du plan de masse gpp2 est réalisée par l'interconnexion vp12 par l'intermédiaire de la zone de plan de masse gpl-p et la couche de caisson wl, formant un trajet semi-conducteur dopé P. La polarisation du plan de masse gpn1 est réalisée par l'interconnexion vn11 par l'intermédiaire de la zone de plan de masse gpl-p et par l'intermédiaire de la couche de caisson wl, formant un trajet semi-conducteur dopé P. La polarisation du plan de masse gpn2 est réalisée par l'interconnexion vn12 par l'intermédiaire de la zone de plan de masse gpl-n formant un trajet semi-conducteur dopé N.

Ainsi, on peut polariser directement chaque plan de masse des transistors par un trajet de semi-conducteur ayant un même type de dopage, même lorsque ces transistors sont séparés des interconnexions par des tranchées d'isolation présentes dans la couche active de semi-conducteur. Ceci est réalisable même pour des rangées comportant des transistors dont les plans de masse ont des dopages de types opposés. Un tel résultat est en outre obtenu au moyen d'une structure simple, avec une couche de caisson présentant un même type de dopage pour des rangées de transistors nMOS et des rangées de transistors pMOS.

Les figures 14 à 19 illustrent différentes variantes de cellules standards pour les cellules de répétition, destinées à la conception de la topologie du circuit intégré 4, tel que défini dans l'exemple des figures 8 et 9.

Les figures 14 et 17 illustrent une première variante de conception d'une cellule de répétition. La figure 14 correspond à la section de cette cellule de répétition au niveau de la couche de caisson. La figure 17 correspond à la section de cette cellule de répétition au niveau de la couche de plan de masse. Dans cet exemple, les interconnexions vp11, vp12 ou vn11, vn12 utilisent une couche commune d'active sur une largeur de pas de grille (illustré par la ligne reliant les interconnexions représentées en projection). Cette variante correspond à l'exemple mis en oeuvre aux figures 8 à 13.

Les figures 15 et 18 illustrent une deuxième variante de conception d'une cellule de répétition. La figure 15 correspond à la section de cette cellule de répétition au niveau de la couche de caisson. La figure 18 correspond à la section de cette cellule de répétition au niveau de la couche de plan de masse. Dans cet exemple, les interconnexions vp11, vp12 ou vn11, vn12 utilisent une couche ou zone distincte d'active sur une largeur de pas de grille.

Les figures 16 et 19 illustrent une troisième variante de conception d'une cellule de répétition. La figure 16 correspond à la section de cette cellule de répétition au niveau de la couche de caisson. La figure 18 correspond à la section de cette cellule de répétition au niveau de la couche de plan de masse. Dans cet exemple, les interconnexions vp11, vp12 ou vn11, vn12 utilisent une couche distincte d'active sur deux fois la largeur de pas de grille.

Ces différentes variantes permettent d'envisager différentes conceptions des cellules de répétition, en fonction des contraintes d'espacement entre les interconnexions adjacentes dans une même rangée de transistors.

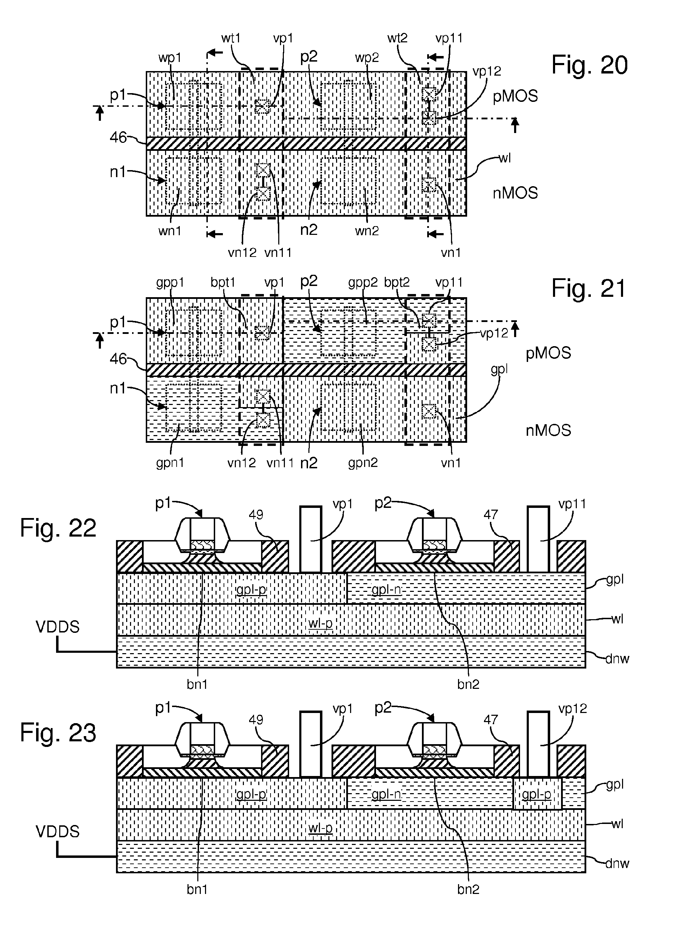

Les figures 20 à 25 illustrent une deuxième variante de structure de la zone 4D selon l'invention, visant à optimiser son fonctionnement. Les figures 20 à 25 sont différentes vues en coupe au niveau d'un groupe de transistors appartenant à des rangées adjacentes et/ou comportant des plans de masse dont les dopages sont de types opposés. Cette deuxième variante nécessite une moindre précision du procédé de fabrication pour réaliser le dopage des différentes zones de la couche de plan de masse.

Comme dans la variante des figures 8 à 13, le groupe de transistors illustré comporte des transistors pMOS p1 et p2 séparés par une tranchée d'isolation 49 dans une première rangée et comporte des transistors nMOS n1 et n2 séparés par une tranchée d'isolation dans une seconde rangée adjacente, les rangées étant séparées par la tranchée d'isolation 46. Les sources, drains et grilles des transistors sont ménagés dans et/ou sur une couche active semi-conductrice, la couche semi-conductrice étant ménagée sur une couche isolante enterrée. Ces transistors sont de type FDSOI.

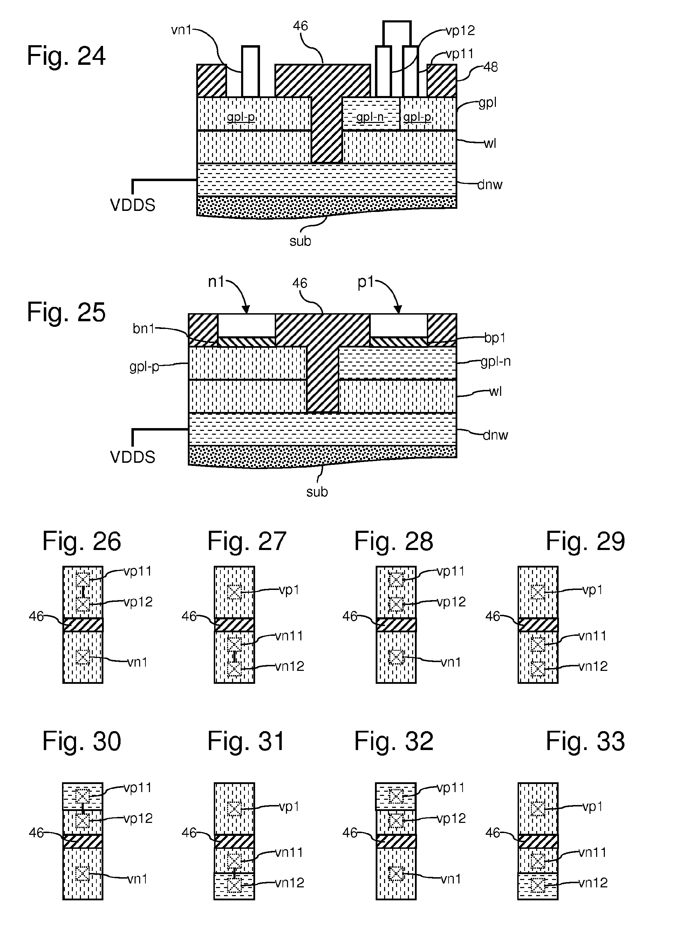

La figure 20 est une vue en coupe de dessus de la zone 4D au niveau de sa couche de caisson wl. La figure 21 est une vue en coupe de dessus de la zone 4D au niveau de sa couche de plan de masse gpl. La figure 22 est une vue en coupe de face de la zone 4D au niveau d'une rangée de transistors pMOS, au niveau de l'interconnexion vp11. La figure 23 est une vue en coupe de face de la zone 4D au niveau d'une rangée de transistors pMOS, au niveau de l'interconnexion vp12. La figure 24 est une vue en coupe de côté de la zone 4D au niveau des interconnexions vp11, vp12 et vn1 de type VIA. La figure 25 est une vue en coupe de côté de la zone 4D au niveau d'une couche active de transistors. Les interconnexions de type VIA vp11, vp12, vp1, vn1, vn11 et vn12 sont ménagées à travers la couche active semi-conductrice et la couche isolante enterrée.

La couche de caisson wl présente deux zones semi-conductrices séparées par la tranchée d'isolation 46. Les deux zones semi-conductrices comportent un dopage de type P. Les zones de caisson wp1, wp2, wn1 et wn2 disposées à l'aplomb respectivement des transistors p1, p2, n1 et n2 comportent ainsi un même dopage de type P. La zone de caisson wt1 est disposée à l'aplomb d'une cellule de répétition incluant les interconnexions vp1, vn11 et vn12. La zone de caisson wt1 est disposée entre les zones de caisson wp1 et wp2. La zone de caisson wt2 est disposée à l'aplomb d'une cellule de répétition incluant les interconnexions vn1, vp11 et vp12.

La couche de plan de masse gpl présente deux zones semi-conductrices séparées par la tranchée d'isolation 46. La zone de plan de masse bpt1 est disposée à l'aplomb de la cellule de répétition incluant les interconnexions vp1, vn11 et vn12. La zone de plan de masse bpt2 est disposée à l'aplomb de la cellule de répétition incluant les interconnexions vn1, vp11 et vp12. A l'aplomb des transistors p1 et n2, sur toute la largeur de leur cellule standard, la couche de plan de masse gpl comporte un dopage de type P. A l'aplomb des transistors p2 et n1, sur toute la largeur de leur cellule standard, la couche de plan de masse gpl comporte un dopage de type N. A l'aplomb des interconnexions vp1 (disposée entre les transistors p1 et p2) et vn2, sur toute la largeur de leur cellule standard, la couche de plan de masse gpl comporte un dopage de type P. A l'aplomb des interconnexions vn12 (disposée entre les transistors n1 et n2) et vp11, sur toute la largeur de leur cellule standard, la couche de plan de masse gpl comporte un dopage de type N. A l'aplomb des interconnexions vn11 (disposée entre les transistors n1 et n2) et vp12, sur toute la largeur de leur cellule standard, la couche de plan de masse gpl comporte un dopage de type P.

Les interconnexions vp1, vn11 et vp12 s'étendent en profondeur jusqu'au contact de la couche de plan de masse gpl, sur une zone gpl-p dopée P. Les interconnexions vn1, vn12 et vp11 s'étendent en profondeur jusqu'au contact de la couche de plan de masse gpl, sur une zone gpl-n dopée N. Un circuit de polarisation non illustré applique des tensions de polarisation sur les interconnexions vp1, vp11, vp12, vn1, vn11 et vn12. Une même tension de polarisation est appliquée sur les interconnexions vp1, vp11 et vp12. Une même tension de polarisation est appliquée sur les interconnexions vn1, vn11 et vn12. La tension de polarisation de l'interconnexion vp1 pourra être distincte de la tension de polarisation de l'interconnexion vn1.

La couche de caisson wl est séparée du substrat sub par l'intermédiaire d'un caisson profondément enterré à dopage de type N dnw. Dans l'exemple, le caisson profondément enterré est polarisé à une tension Vdds. La tranchée d'isolation 46 s'étend en profondeur jusqu'au caisson profondément enterré dnw.

La polarisation du plan de masse gpp1 est réalisée par l'interconnexion vp12 par l'intermédiaire de la zone de plan de masse gpl-p et de la couche de plan de masse wl, formant un trajet semi-conducteur dopé P (et de façon redondante par l'interconnexion vp1 par l'intermédiaire de la zone de plan de masse gpl-p formant un trajet semi-conducteur dopé P). La polarisation du plan de masse gpp2 est réalisée par l'interconnexion vp11 par l'intermédiaire de la zone de plan de masse gpl-n formant un trajet semi-conducteur dopé N. La polarisation du plan de masse gpn1 est réalisée par l'interconnexion vn12 par l'intermédiaire de la zone de plan de masse gpl-n. La polarisation du plan de masse gpn2 est réalisée par l'interconnexion vn11 et l'interconnexion vn1 par l'intermédiaire de la zone de plan de masse gpl-p.

Ainsi, on peut polariser directement chaque plan de masse des transistors par un trajet de semi-conducteur ayant un même type de dopage, même lorsque ces transistors sont séparés des interconnexions par des tranchées d'isolation présentes dans la couche active de semi-conducteur.

Dans cette structure, les interconnexions vp1, vp12 et vn1, vn11 assurent une redondance de polarisation de leur caisson respectif. Une moindre homogénéité de polarisation serait également obtenue en supprimant les interconnexions vp12 et vn11 tout en permettant un fonctionnement satisfaisant du circuit intégré. Une telle suppression faciliterait notamment le procédé de fabrication du circuit intégré.

Les figures 26 à 37 illustrent différentes variantes de cellules standards pour les cellules de répétition, destinées à la conception de la topologie du circuit intégré 4, tel que défini dans l'exemple des figures 20 et 21.

Les figures 26 et 30 illustrent une première variante de conception d'une cellule de répétition. La figure 26 correspond à la section de cette cellule de répétition au niveau de la couche de caisson. La figure 30 correspond à la section de cette cellule de répétition au niveau de la couche de plan de masse. Dans cet exemple, les interconnexions vp11 et vp12 utilisent une couche commune d'active sur une largeur de pas de grille (illustré par la ligne reliant les interconnexions représentées en projection). Cette variante correspond à l'exemple mis en oeuvre aux figures 20 à 25.

Les figures 27 et 31 illustrent un complément de la première variante de conception d'une cellule de répétition. La figure 27 correspond à la section de cette cellule de répétition au niveau de la couche de caisson. La figure 31 correspond à la section de cette cellule de répétition au niveau de la couche de plan de masse. Dans cet exemple, les interconnexions vn11 et vn12 utilisent une couche commune d'active sur une largeur de pas de grille. Cette variante correspond à l'exemple mis en oeuvre aux figures 20 à 25.

Les figures 28 et 32 illustrent une deuxième variante de conception d'une cellule de répétition. La figure 28 correspond à la section de cette cellule de répétition au niveau de la couche de caisson. La figure 32 correspond à la section de cette cellule de répétition au niveau de la couche de plan de masse. Dans cet exemple, les interconnexions vp11 et vp12 utilisent une couche distincte d'active sur une largeur de pas de grille. Les dopages des couches de plan de masse et de caisson sont identiques à ceux de la variante des figures 26 et 30.

Les figures 29 et 33 illustrent un complément de la deuxième variante de conception d'une cellule de répétition. La figure 29 correspond à la section de cette cellule de répétition au niveau de la couche de caisson. La figure 33 correspond à la section de cette cellule de répétition au niveau de la couche de plan de masse. Dans cet exemple, les interconnexions vn11 et vn12 utilisent une couche distincte d'active sur une largeur de pas de grille. Les dopages des couches de plan de masse et de caisson sont identiques à ceux de la variante des figures 27 et 31.

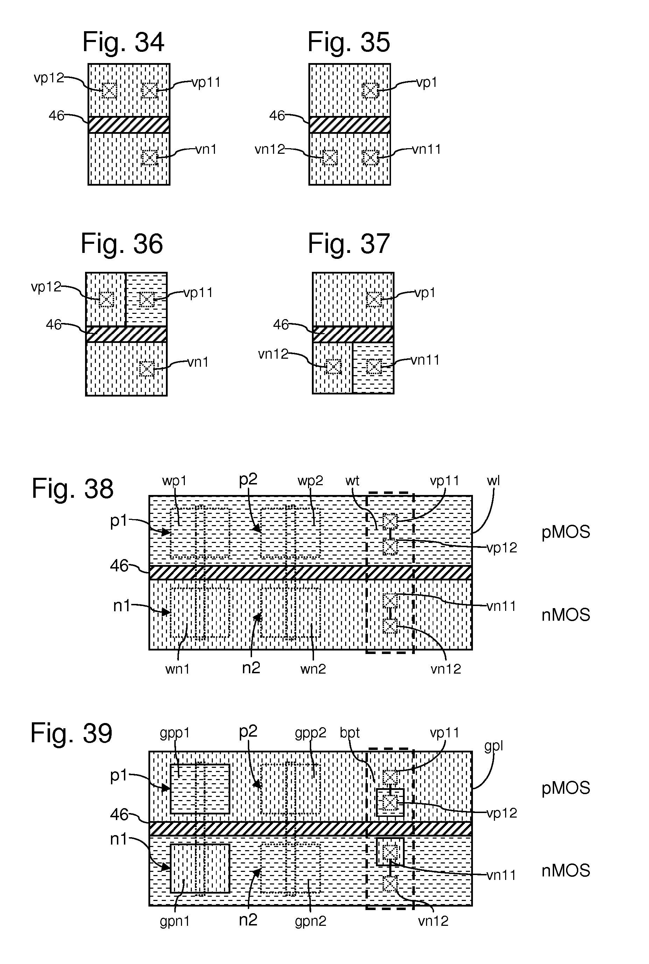

Les figures 34 et 36 illustrent une troisième variante de conception d'une cellule de répétition. La figure 34 correspond à la section de cette cellule de répétition au niveau de la couche de caisson. La figure 36 correspond à la section de cette cellule de répétition au niveau de la couche de plan de masse. Dans cet exemple, les interconnexions vn1, vp11 et vp12 utilisent une couche distincte d'active sur deux fois la largeur de pas de grille.

Les figures 35 et 37 illustrent un complément de la troisième variante de conception d'une cellule de répétition. La figure 35 correspond à la section de cette cellule de répétition au niveau de la couche de caisson. La figure 37 correspond à la section de cette cellule de répétition au niveau de la couche de plan de masse. Dans cet exemple, les interconnexions vp1, vn11 et vn12 utilisent une couche distincte d'active sur une largeur de pas de grille.

Les figures 38 et 39 illustrent une troisième variante de structure de circuit intégré selon l'invention, visant à optimiser son fonctionnement. Les figures 38 et 39 sont des vues en coupe de dessus au niveau d'un groupe de transistors appartenant à des rangées adjacentes et/ou comportant des plans de masse dont les dopages sont de types opposés. La figure 38 est une vue en coupe de la structure au niveau de sa couche de caisson wl. La figure 39 est une vue en coupe de dessus de la structure au niveau de sa couche de plan de masse gpl.

Comme dans la variante des figures 8 à 13, le groupe de transistors illustré comporte des transistors pMOS p1 et p2 séparés par une tranchée d'isolation dans une première rangée et comporte des transistors nMOS n1 et n2 séparés par une tranchée d'isolation 49 dans une seconde rangée adjacente, les rangées étant séparées par la tranchée d'isolation 46. Les sources, drains et grilles des transistors sont ménagés dans et/ou sur une couche active semi-conductrice, la couche semi-conductrice étant ménagée sur une couche isolante enterrée. Ces transistors sont de type FDSOI.

La structure comporte des interconnexions vp11, vp12, vn11 et vn12 de type VIA. Les interconnexions de type VIA vp11, vp12, vn11 et vn12 sont ménagées à travers la couche active semi-conductrice et la couche isolante enterrée.

La couche de caisson wl présente deux zones semi-conductrices séparées par la tranchée d'isolation 46. La zone semi-conductrice à l'aplomb des transistors nMOS comporte un dopage de type P. la zone semi-conductrice à l'aplomb des transistors pMOS comporte un dopage de type N. Les zones de caisson wp1 et wp2 disposées à l'aplomb respectivement des transistors p1 et p2 comportent ainsi un même dopage de type N. Les zones de caisson wn1 et wn2, disposées à l'aplomb respectivement des transistors n1 et n2 comportent ainsi un même dopage de type P. La zone de caisson wt est disposée à l'aplomb d'une cellule de répétition incluant les interconnexions vp11, vp12, vn11 et vn12.

La couche de plan de masse gpl présente deux zones semi-conductrices séparées par la tranchée d'isolation 46. La zone de plan de masse bpt est disposée à l'aplomb de la cellule de répétition incluant les interconnexions vp11, vp12, vn11 et vn12. La zone semi-conductrice correspondant aux nMOS comporte un dopage de type P sur l'ensemble de sa surface, à l'exception de la zone de plan de masse gpp1 disposée à l'aplomb du transistor p1 (qui forme comme un îlot dans une zone de plan de masse gpl-p dopée P). La zone de plan de masse gpp2 présente ainsi un dopage de type P. La zone semi-conductrice correspondant aux pMOS comporte un dopage de type N sur l'ensemble de sa surface, à l'exception de la zone de plan de masse gpn1 disposée à l'aplomb du transistor n1 (qui forme comme un îlot dans une zone de plan de masse gpl-n dopée N). La zone de plan de masse gpn2 présente ainsi un dopage de type N.

Les interconnexions vp11 et vn12 s'étendent en profondeur jusqu'au contact de la couche de plan de masse gpl, sur une zone gpl-p dopée P. Les interconnexions vn12 et vp11 s'étendent en profondeur jusqu'au contact de la couche de plan de masse gpl, sur une zone gpl-n dopée N. Un circuit de polarisation non illustré applique des tensions de polarisation sur les interconnexions vp11, vp12, vn11 et vn12. Une même tension de polarisation est appliquée sur les interconnexions vp11 et vp12. Une même tension de polarisation est appliquée sur les interconnexions vn11 et vn12. La tension de polarisation de l'interconnexion vp11 pourra être distincte de la tension de polarisation de l'interconnexion vn11.

La couche de caisson wl est séparée du substrat sub par l'intermédiaire d'un caisson profondément enterré à dopage de type N dnw. Dans l'exemple, le caisson profondément enterré est polarisé à une tension Vdds. La tranchée d'isolation 46 s'étend en profondeur jusqu'au caisson profondément enterré dnw.

La polarisation du plan de masse gpp2 est réalisée par l'interconnexion vp11 par l'intermédiaire de la zone de plan de masse gpl-p dopée P. La polarisation du plan de masse gpp1 est réalisée par l'interconnexion vp12 par l'intermédiaire de la zone gpl-n de la couche de plan de masse et par l'intermédiaire du caisson dopé N, formant ainsi un trajet semi-conducteur dopé N.

La polarisation du plan de masse gpn2 est réalisée par l'interconnexion vn12 par l'intermédiaire de la zone de plan de masse gpl-n dopée N. La polarisation du plan de masse gpn1 est réalisée par l'interconnexion vn11 par l'intermédiaire de la zone gpl-p de la couche de plan de masse et par l'intermédiaire du caisson dopé P, formant ainsi un trajet semi-conducteur dopé P.

Ainsi, on peut polariser directement chaque plan de masse des transistors par un trajet de semi-conducteur ayant un même type de dopage, même lorsque ces transistors sont séparés des interconnexions par des tranchées d'isolation présentes dans la couche active de semi-conducteur.

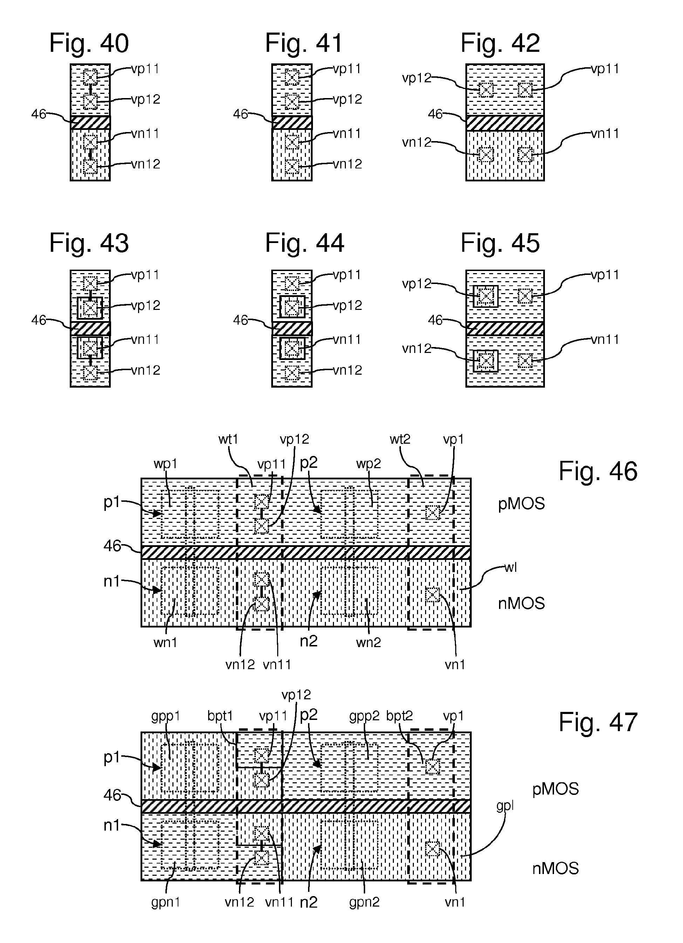

Les figures 40 à 45 illustrent différentes variantes de cellules standards pour les cellules de répétition, destinées à la conception de la topologie du circuit intégré 4, tel que défini dans l'exemple des figures 38 et 39.

Les figures 40 et 43 illustrent une première variante de conception d'une cellule de répétition. La figure 40 correspond à la section de cette cellule de répétition au niveau de la couche de caisson. La figure 43 correspond à la section de cette cellule de répétition au niveau de la couche de plan de masse. Dans cet exemple, les interconnexions vp11, vp12 ou vn11, vn12 utilisent une couche commune d'active sur une largeur de pas de grille (illustré par la ligne reliant les interconnexions représentées en projection). Cette variante correspond à l'exemple mis en oeuvre aux figures 38 et 39.

Les figures 41 et 44 illustrent une deuxième variante de conception d'une cellule de répétition. La figure 41 correspond à la section de cette cellule de répétition au niveau de la couche de caisson. La figure 44 correspond à la section de cette cellule de répétition au niveau de la couche de plan de masse. Dans cet exemple, les interconnexions vp11, vp12 ou vn11, vn12 utilisent une couche ou zone distincte d'active sur une largeur de pas de grille.

Les figures 42 et 45 illustrent une troisième variante de conception d'une cellule de répétition. La figure 42 correspond à la section de cette cellule de répétition au niveau de la couche de caisson. La figure 45 correspond à la section de cette cellule de répétition au niveau de la couche de plan de masse. Dans cet exemple, les interconnexions vp11, vp12 ou vn11, vn12 utilisent une couche distincte d'active sur deux fois la largeur de pas de grille.

Les figures 46 et 47 illustrent une quatrième variante de structure de circuit intégré selon l'invention, visant à optimiser son fonctionnement. Les figures 46 à 47 sont des vues en coupe de dessus au niveau d'un groupe de transistors appartenant à des rangées adjacentes et/ou comportant des plans de masse dont les dopages sont de types opposés. La figure 46 est une vue en coupe de la structure au niveau de sa couche de caisson wl. La figure 47 est une vue en coupe de dessus de la structure au niveau de sa couche de plan de masse gpl.

Comme dans la variante des figures 20 et 21, le groupe de transistors illustré comporte des transistors pMOS p1 et p2 séparés par une tranchée d'isolation dans une première rangée et comporte des transistors nMOS n1 et n2 séparés par une tranchée d'isolation dans une seconde rangée adjacente, les rangées étant séparées par la tranchée d'isolation 46. Les sources, drains et grilles des transistors sont ménagés dans et/ou sur une couche active semi-conductrice, la couche semi-conductrice étant ménagée sur une couche isolante enterrée. Ces transistors sont de type FDSOI.

La structure comporte des interconnexions vp1, vp11, vp12, vn1, vn11 et vn12 de type VIA. Les interconnexions de type VIA vp1, vp11, vp12, vn1, vn11 et vn12 sont ménagées à travers la couche active semi-conductrice et la couche isolante enterrée.

La zone semi-conductrice à l'aplomb des transistors nMOS comporte un dopage de type P. la zone semi-conductrice à l'aplomb des transistors pMOS comporte un dopage de type N. Les zones de caisson wp1 et wp2 disposées à l'aplomb respectivement des transistors p1 et p2 comportent ainsi un même dopage de type N. Les zones de caisson wn1 et wn2, disposées à l'aplomb respectivement des transistors n1 et n2 comportent ainsi un même dopage de type P. La zone de caisson wt1 est disposée à l'aplomb d'une cellule de répétition incluant les interconnexions vp11, vp12, vn11 et vn12. La zone de caisson wt1 est disposée entre les zones de caisson wp1 et wp2. La zone de caisson wt2 est disposée à l'aplomb d'une cellule de répétition incluant les interconnexions vp1 et vn1.

La couche de plan de masse gpl présente deux zones semi-conductrices séparées par la tranchée d'isolation 46. La zone de plan de masse bpt1 est disposée à l'aplomb de la cellule de répétition incluant les interconnexions vp11, vp12, vn11 et vn12. La zone de plan de masse bpt2 est disposée à l'aplomb de la cellule de répétition incluant les interconnexions vn1 et vp1. A l'aplomb des transistors p1 et n2, sur toute la largeur de leur cellule standard, la couche de plan de masse gpl comporte un dopage de type P. A l'aplomb des transistors p2 et n1, sur toute la largeur de leur cellule standard, la couche de plan de masse gpl comporte un dopage de type N. A l'aplomb des interconnexions vp11 (disposée entre les transistors p1 et p2) et vn12 (disposée entre les transistors n1 et n2), sur toute la largeur de leur cellule standard, la couche de plan de masse gpl comporte un dopage de type N. A l'aplomb des interconnexions vp12 (disposée entre les transistors p1 et p2) et vn11 (disposée entre les transistors n1 et n2), sur toute la largeur de leur cellule standard, la couche de plan de masse gpl comporte un dopage de type P.

Les interconnexions vn1, vn11 et vp12 s'étendent en profondeur jusqu'au contact de la couche de plan de masse gpl, sur une zone gpl-p dopée P. Les interconnexions vp1, vn12 et vp11 s'étendent en profondeur jusqu'au contact de la couche de plan de masse gpl, sur une zone gpl-n dopée N. Un circuit de polarisation non illustré applique des tensions de polarisation sur les interconnexions vp1, vp11, vp12, vn1, vn11 et vn12. Une même tension de polarisation est appliquée sur les interconnexions vp1, vp11 et vp12. Une même tension de polarisation est appliquée sur les interconnexions vn1, vn11 et vn12. La tension de polarisation de l'interconnexion vp1 pourra être distincte de la tension de polarisation de l'interconnexion vn1.

La couche de caisson wl est séparée du substrat sub par l'intermédiaire d'un caisson profondément enterré à dopage de type N dnw. Dans l'exemple, le caisson profondément enterré est polarisé à une tension Vdds. La tranchée d'isolation 46 s'étend en profondeur jusqu'au caisson profondément enterré dnw.

La polarisation du plan de masse gpp1 est réalisée par l'interconnexion vp12 par l'intermédiaire de la zone de plan de masse gpl-p formant un trajet semi-conducteur dopé P. La polarisation du plan de masse gpp2 est réalisée par l'interconnexion vp1 par l'intermédiaire de la zone de plan de masse gpl-n formant un trajet semi-conducteur dopé N. La polarisation du plan de masse gpp2 est réalisée de façon redondante par l'interconnexion vp11 par l'intermédiaire de la zone de plan de masse gpl-n, qui permet en outre d'assurer une redondance de polarisation de la couche de caisson à l'aplomb des transistors pMOS. L'homogénéité de la polarisation de la couche de caisson est ainsi accrue.

La polarisation du plan de masse gpn1 est réalisée par l'interconnexion vn12 par l'intermédiaire de la zone de plan de masse gpl-n formant un trajet semi-conducteur dopé N. La polarisation du plan de masse gpn2 est réalisée par l'interconnexion vn1 par l'intermédiaire de la zone de plan de masse gpl-p formant un trajet semi-conducteur dopé P. La polarisation du plan de masse gpn2 est réalisée de façon redondante par l'interconnexion vn11 par l'intermédiaire de la zone de plan de masse gpl-p, qui permet en outre d'assurer une redondance de polarisation de la couche de caisson à l'aplomb des transistors nMOS. L'homogénéité de la polarisation de la couche de caisson est ainsi accrue.

Comme pour les autres variantes, on réalise une polarisation directe du plan de masse d'un transistor par un trajet direct de semi-conducteur présentant un même type de dopage.

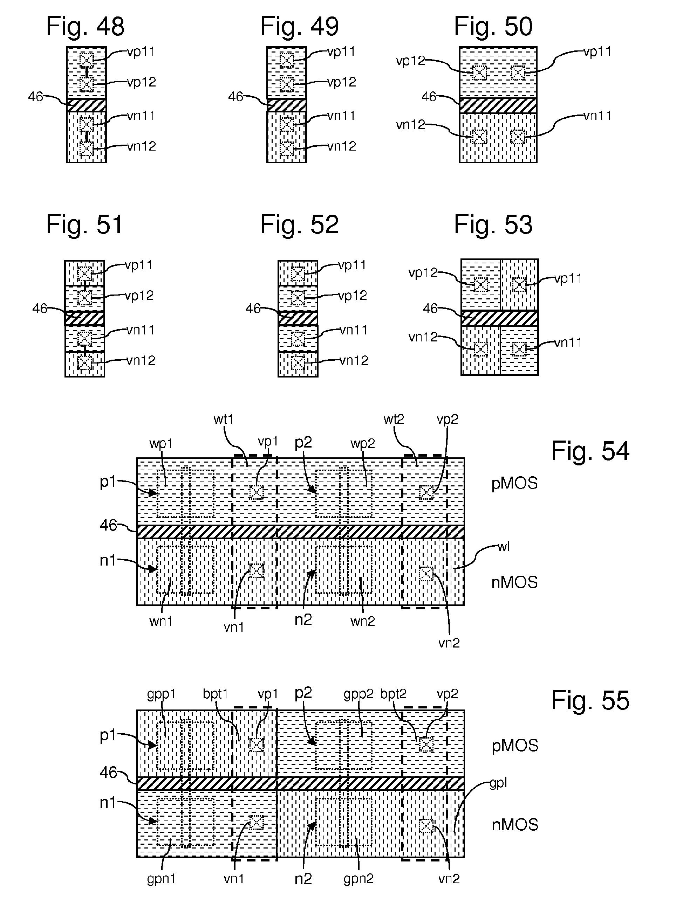

Les figures 48 à 53 illustrent différentes variantes de cellules standards pour les cellules de répétition, destinées à la conception de la topologie du circuit intégré 4, tel que défini dans l'exemple des figures 46 et 47.

Les figures 48 et 51 illustrent une première variante de conception d'une cellule de répétition. La figure 48 correspond à la section de cette cellule de répétition au niveau de la couche de caisson. La figure 51 correspond à la section de cette cellule de répétition au niveau de la couche de plan de masse. Dans cet exemple, les interconnexions vp11, vp12 ou vn11, vn12 utilisent une couche commune d'active sur une largeur de pas de grille (illustré par la ligne reliant les interconnexions représentées en projection). Cette variante correspond à l'exemple mis en oeuvre aux figures 46 et 47.

Les figures 49 et 52 illustrent une deuxième variante de conception d'une cellule de répétition. La figure 49 correspond à la section de cette cellule de répétition au niveau de la couche de caisson. La figure 52 correspond à la section de cette cellule de répétition au niveau de la couche de plan de masse. Dans cet exemple, les interconnexions vp11, vp12 ou vn11, vn12 utilisent une couche ou zone distincte d'active sur une largeur de pas de grille.

Les figures 50 et 53 illustrent une troisième variante de conception d'une cellule de répétition. La figure 50 correspond à la section de cette cellule de répétition au niveau de la couche de caisson. La figure 53 correspond à la section de cette cellule de répétition au niveau de la couche de plan de masse. Dans cet exemple, les interconnexions vp11, vp12 ou vn11, vn12 utilisent une couche distincte d'active sur deux fois la largeur de pas de grille.

Les figures 54 et 55 illustrent une déclinaison de la quatrième variante de structure de circuit intégré selon l'invention, visant à simplifier sa structure. Les figures 54 et 55 sont des vues en coupe de dessus au niveau d'un groupe de transistors appartenant à des rangées adjacentes et/ou comportant des plans de masse dont les dopages sont de types opposés. La figure 54 est une vue en coupe de la structure au niveau de sa couche de caisson wl. La figure 55 est une vue en coupe de dessus de la structure au niveau de sa couche de plan de masse gpl.

Par comparaison à la variante des figures 46 et 47, la cellule de répétition placée entre les transistors p1 et p2 comporte culture simplifiée. Cette cellule de répétition comporte seulement une interconnexion vp1 pour le transistor p1, et une interconnexion vn1 pour le transistor n1. La zone de plan de masse bpt1 disposée à l'aplomb de la cellule de répétition comporte un dopage de type P entre les transistors p1 et p2, et un dopage de type N entre les transistors n1 et n2.

La couche de caisson à l'aplomb des transistors pMOS est ici polarisée uniquement par l'intermédiaire de la zone bpt2 de la cellule de répétition incluant l'interconnexion vp1. La couche de caisson à l'aplomb des transistors nMOS est ici polarisée uniquement par l'intermédiaire de la zone bpt2 de la cellule de répétition incluant l'interconnexion vn1. Bien que la polarisation de la couche de caisson wl puisse être moins homogène que dans l'exemple des figures 46 et 47, cette homogénéité peut s'avérer suffisante tout en facilitant le procédé de fabrication du circuit intégré.

## Revendications

1. Circuit intégré comprenant un empilement d'un substrat semi-conducteur (sub), d'une couche isolante enterrée (bn2) et d'une couche semi-conductrice, **caractérisé en ce qu'il** comprend :
- un premier composant électronique (n2) formé dans et/ou sur ladite couche semi-conductrice :
- un circuit de polarisation configuré pour générer une première tension de polarisation ;
- des première (vn12) et deuxième interconnexions de type VIA, sur lesquelles le circuit de polarisation applique une même tension de polarisation égale à la première tension de polarisation ;
- au moins une première tranchée d'isolation (47) séparant le premier composant électronique (n2) des première et deuxième interconnexions dans la couche semi-conductrice ;
- un premier plan de masse (gpl-n) présentant un premier type de dopage, disposé sous la couche isolante enterrée (bn2) à l'aplomb du premier composant électronique (n2), et s'étendant sous la première tranchée d'isolation (47) et jusqu'en contact avec la première interconnexion (vn12) ;
- un premier caisson (wl-p) présentant un deuxième type de dopage opposé au premier type, disposé à l'aplomb du premier plan de masse (gpl-n), et s'étendant sous la première tranchée d'isolation (47) et jusqu'en contact avec la deuxième interconnexion (vn11).

2. Circuit intégré (4) selon la revendication 1, comprenant en outre :
- un deuxième composant électronique (n1) formé dans et/ou sur ladite couche semi-conductrice :
- un deuxième plan de masse (gpn1) présentant le deuxième type de dopage, disposé à l'aplomb de la couche isolante enterrée (bn1) à l'aplomb du deuxième composant électronique (n1), le premier caisson (wl-p) s'étendant jusqu'en contact avec le deuxième plan de masse (gpn1).

3. Circuit intégré (4) selon la revendication 2, dans lequel ledit premier caisson comporte une jonction (gpl-p) présentant le deuxième type de dopage et s'étendant dans une même couche que les premier et deuxième plans de masse jusqu'à la deuxième interconnexion (vn11).

4. Circuit intégré (4) selon la revendication 2 ou 3, dans lequel les premier et deuxième composants électroniques (n2, n1) sont des transistors FDSOI de même type nMOS ou pMOS.

5. Circuit intégré selon la revendication 4, dans lequel les premier et deuxième transistors sont disposés dans une même rangée de transistors, le deuxième plan de masse (gpn1) étant entouré de semi-conducteur présentant le premier type de dopage dans la couche incluant les premier et deuxième plans de masse (gpn2, gpn1).

6. Circuit intégré selon la revendication 4, dans lequel les premier et deuxième transistors sont disposés dans une même rangée de transistors, le deuxième plan de masse (gpn1) s'étendant sur la largeur de la rangée.

7. Circuit intégré selon l'une quelconque des revendications 4 à 6, comprenant une jonction électrique connectant lesdites première et deuxième interconnexions (vn11, vn12) dans la couche semi-conductrice, lesdites première et deuxième interconnexions étant ménagées dans une même cellule de répétition présentant une largeur d'un pas de grille du premier transistor.

8. Circuit intégré selon l'une quelconque des revendications 4 à 6, ne comprenant pas de jonction électrique connectant lesdites première et deuxième interconnexions (vn11, vn12) dans la couche semi-conductrice, lesdites première et deuxième interconnexions étant ménagées dans une même cellule de répétition présentant une largeur d'un pas de grille du premier transistor.

9. Circuit intégré selon l'une quelconque des revendications 4 à 6, ne comprenant pas de jonction électrique connectant lesdites première et deuxième interconnexions (vn11, vn12) dans la couche semi-conductrice, lesdites première et deuxième interconnexions étant ménagées dans une même cellule de répétition présentant une largeur de deux pas de grille du premier transistor.

10. Circuit intégré selon l'une quelconque des revendications 6 à 9, comprenant en outre :
- un troisième transistor FDSOI (p1) d'un type opposé au premier transistor, formé dans et/ou sur ladite couche semi-conductrice ;
- un quatrième transistor FDSOI (p2) du même type que le troisième transistor et formé dans et/ou sur ladite couche semi-conductrice ;
- le circuit de polarisation étant configuré pour générer une deuxième tension de polarisation ;
- des troisième (vp11) et quatrième interconnexions (vp12) de type VIA, sur lesquelles le circuit de polarisation applique une même tension de polarisation égale à la deuxième tension de polarisation ;
- au moins une deuxième tranchée d'isolation (47) séparant le troisième transistor (p1) des troisième et quatrième interconnexions dans la couche semi-conductrice ;
- un troisième plan de masse (gpp1) présentant un troisième type de dopage, disposé sous la couche isolante enterrée (bn1) à l'aplomb du troisième transistor (p1), et s'étendant sous la première tranchée d'isolation (47) et jusqu'en contact avec la troisième interconnexion (vp11) ;
- un deuxième caisson (wl-p) présentant un quatrième type de dopage opposé au troisième type, disposé à l'aplomb du troisième plan de masse (gpp1), et s'étendant sous la première tranchée d'isolation (47) et jusqu'en contact avec la quatrième interconnexion (vp12) ;
- un quatrième plan de masse (gpp2) présentant le quatrième type de dopage, disposé à l'aplomb de la couche isolante enterrée (bn2) à l'aplomb du quatrième transistor (p2), le deuxième caisson (wl-p) s'étendant jusqu'en contact avec le quatrième plan de masse.

11. Circuit intégré selon la revendication 10, dans lequel les premier et deuxième caissons présentent un même type de dopage.

12. Circuit intégré selon l'une quelconque des revendications précédentes, dans lequel ledit premier caisson est séparé du substrat (sub) par un caisson profondément enterré (dnw) ménagé à l'aplomb du premier caisson.

13. Circuit intégré selon l'une quelconque des revendications précédentes, dans lequel ledit substrat (sub) présente un dopage de type P.
